# EUROPEAN PATENT APPLICATION

(11) **EP 3 882 988 A1**
(43) Date of publication of application: **22.09.2021**
(21) Application number: 18940448.6
(22) Date of filing: 13.11.2018
(51) Int. Cl.: H01L 33/00, H01L 33/10, H01L 33/60

(54) **LIGHT-EMITTING DIODE**

(71) Applicant: Xiamen San'an Optoelectronics Technology Co., Ltd., Siming Dist. Xiamen, Fujian 361009 (CN)
(72) Inventor: GUO, Guitian, Xiamen, Fujian 361009 (CN); ZHU, Liqin, Xiamen, Fujian 361009 (CN); CAI, Linrong, Xiamen, Fujian 361009 (CN); YANG, Lixun, Xiamen, Fujian 361009 (CN)
(74) Representative: Petraz, Gilberto Luigi
(86) International application number: PCT/CN2018/115246
(87) International publication number: WO 2020/097792

(57) **Abstract**

Disclosed is a light-emitting diode. In some embodiments, the light-emitting diode comprises: a light-emitting epitaxial laminated layer, which includes a first semiconductor layer, an active layer and a second semiconductor layer, and is provided with a corresponding first surface and second surface; a light-transmitting layer, which is formed on the second surface of the light-emitting epitaxial laminated layer; a first metal layer, which is formed on one surface, away from the light-emitting epitaxial laminated layer, of the light-transmitting layer; and a second metal layer, which is formed on one surface, away from the light-emitting epitaxial laminated layer, of the first metal layer, wherein the first metal layer and the second metal layer constitute a mirror plane structure.

## Description

### TECHNICAL FIELD

The present invention relates to the field of semiconductor optoelectronic technology, and more particularly to a light-emitting diode structure.

### BACKGROUND

Light-emitting diodes are widely used as solid state lighting light sources. Compared with traditional incandescent lamps and fluorescent lamps, the light-emitting diodes have advantages of low power consumption and long lifetime, and therefore the light-emitting diodes have gradually replaced traditional light sources, and are applied to various fields, such as traffic signs, backlight modules, pedestrian lights, medical devices, etc. To improve the light-emitting efficiency of the light-emitting diode, a reflective layer is usually arranged below an epitaxial sheet, and light emitted downward from an active layer is reflected back through the reflective layer, thereby increasing the light-emitting efficiency.

### SUMMARY

### TECHNICAL PROBLEM

### SOLUTION SOLVING THE TECHNICAL PROBLEM

### TECHNICAL SOLUTION

The present invention provides a light-emitting diode, which effectively improves external light-emitting efficiency of the light-emitting diode.

A light-emitting diode according to a first aspect of the present invention includes: a light-emitting epitaxial layered structure including a first semiconductor layer, an active layer and a second semiconductor layer, and having a first surface and a second surface corresponding to each other; a light-transmitting layer formed on the second surface of the light-emitting epitaxial layered structure; a first metal layer formed on a surface of the light-transmitting layer away from the light-emitting epitaxial layered structure; a second metal layer formed on a surface of the first metal layer away from the light-emitting epitaxial layered structure. The first metal layer and the second metal layer form a mirror surface structure. The first metal layer has a reflectance R1 to light emitted from the light-emitting epitaxial layered structure, the second metal layer having a reflectance R2 to light emitted from the light-emitting epitaxial layered structure, and the first metal layer and the second metal layer having a combined reflectance R3 to the light emitted from the light-emitting epitaxial layered structure, wherein R1< R2, and (R2-R3)/R2<4%.

In some embodiments, an emission wavelength of the light-emitting epitaxial layered structure is 385-450 nm, and the combined reflectance of the first metal layer and the second metal layer is 90% or more.

In some embodiments, an emission wavelength of the light-emitting epitaxial layered structure is 365-450 nm, and the combined reflectance of the first metal layer and the second metal layer is 85% or more.

According to a second aspect of the present invention, an ultraviolet light-emitting diode is provided, including: a light-emitting epitaxial layered structure including a first semiconductor layer, an active layer and a second semiconductor layer, and having a first surface and a second surface corresponding to each other; a light-transmitting layer formed on the second surface of the light-emitting epitaxial layered structure; a first conductive layer formed on a surface of the light-transmitting layer away from the light-emitting epitaxial layered structure; a second conductive layer formed on a surface of the first conductive layer away from the light-emitting epitaxial layered structure. The first conductive layer and the second conductive layer form a mirror surface structure. The first conductive layer has a reflectance R2 to light emitted from the light-emitting epitaxial layered structure, the second conductive layer having a reflectance R2 to light emitted from the light-emitting epitaxial layered structure, and the first conductive layer and the second conductive layer having a combined reflectance R3 to the light emitted from the light-emitting epitaxial layered structure, wherein R1< R2, and (R2-R3)/R2<4%.

According to a third aspect of the present invention, a light-emitting diode is provided, including an upper part and a lower part. The upper part is a semiconductor layered structure which sequentially includes a first semiconductor layer, an active layer and a second semiconductor layer from top to bottom. The lower part includes an insulating material layer, an adhesive layer and a substrate in sequence. The lower part has an edge part exceeding the upper edge. The edge part includes at least a first insulating layer, a metal material layer and a second insulating layer, an adhesive layer and a substrate from top to bottom.

In some embodiments, the lower surface of the semiconductor layered structure is sequentially provided with the first insulating layer, the metal reflective layer, the metal protection layer and the second insulating layer.

Preferably, the metal protection layer is made of the same material as the metal material layer at the edge part. In other embodiments, the material of the metal protection layer and the metal material layer of the edge part may also be different.

In some embodiments, the metal protection layer is electrically isolated from the metal material layer of the edge part.

Preferably, the metal material layer of the edge part is located at an outermost side of the outer edge part.

In some embodiments, the semiconductor layered structure has at least one recess extending from a lower surface of the semiconductor layered structure through the second semiconductor layer, the active layer to the first type of semiconductor layer, and the first insulating layer covers a sidewall of the recess.

Further, the light-emitting diode further includes a first conductive connection layer, which is formed on a surface of the first insulating layer and fills the recess, and forms an electrical connection with the first semiconductor layer; and a second conductive connection layer, which is formed between the first insulating layer and the second insulating layer and forms an electrically connection with the second semiconductor layer. The second conductive connection layer includes a metal reflective layer and a metal protection layer. Preferably, the metal protection layer is made of the same material as the metal material layer at the edge part.

In some embodiments, the second conductive connection layer further includes a conductive adhesion layer disposed between the metal reflective layer and the first insulating layer.

### Beneficial effects of the present invention

### Beneficial effects

Other features and advantages of the invention will be set forth in the description which follows and, in part, will be apparent from the description, or will be appreciated by practice of the invention. Objects and other advantages of the present invention may be achieved and obtained by structures particularly pointed out in the description, claims, and drawings.

### BRIEF DESCRIPTION OF THE DRAWINGS

### DESCRIPTION OF THE DRAWINGS

The accompanying drawings are used to provide a further understanding of the present invention and form a part of the description, together with the embodiments of the present invention, for explaining the present invention, and do not constitute a limitation on the present invention. In addition, the drawing data is an overview of the description and is not drawn to scale.
FIG. 1 is a schematic structural diagram of a light-emitting diode according to a first embodiment of the present invention.
FIG. 2 shows a reflectance curve of different materials for different wavelengths of light.
FIG. 3 is a schematic structural diagram of a light-emitting diode according to a second embodiment of the present invention.
FIG. 4 is a schematic diagram illustrating that an edge of the metal reflective layer of the light-emitting diode exceeds an edge of an epitaxial layered structure according to a second preferred embodiment.
FIG. 5 is a schematic structural diagram of a light-emitting diode according to a third embodiment of the present invention.
FIG. 6 shows a manufacturing process of a light-emitting diode chip according to a fourth embodiment of the present invention.
FIGS. 7-19 are schematic diagrams illustrating the structures presented in various steps in the manufacturing process of a light-emitting diode according to a fourth embodiment of the present invention.
FIG. 20 to FIG. 25 are schematic diagrams showing a structure presented by a part of steps in the manufacturing process of a light-emitting diode according to a fifth embodiment of the present invention, in which FIG. 23 shows photos of a cutting path in the manufacturing process of the light-emitting diode according to the fourth embodiment and the fifth embodiment, respectively.
FIG. 26 is a schematic structural diagram of a light-emitting diode according to a sixth embodiment of the present invention.
FIG. 27 is a schematic structural diagram of a light-emitting diode according to a seventh embodiment of the present invention.

### EMBODIMENTS OF THE INVENTION

### EMBODIMENTS OF THE PRESENT INVENTION

Structures, ratios, sizes, and the like shown in the figures of the present description are only used to cooperate with the contents disclosed in the description for the understanding and reading of those familiar with the technology, and are not used to limit the implementation of the present invention, so it has no technical significance. Any structural modification, proportional relationship change or size adjustment should still fall within the scope of the technical content disclosed in the present invention without affecting the effects and objectives that the present invention can produce. Meanwhile, the terms such as "upper", "lower", "left", "right", "middle" and "a/an" referred to in this description are merely for convenience of description, and are not intended to limit the scope to which the present invention can be implemented, and the relative relationship is changed or adjusted, and without substantive change of technical contents, the present invention is also considered to be the scope to which the present invention can be implemented.

The structure of the light-emitting diode of the present invention is described in detail below with reference to the accompanying drawings, and thus how to apply technical means to solve the technical problem, and the implementation process for achieving the technical effects can be fully understood and can be implemented. It should be noted that, as long as the conflict is not constituted, various embodiments of the present invention and various features of the embodiments may be combined with each other, and the formed technical solutions are within the scope of protection of the present invention.

### Embodiment 1

In order to further improve the light-emitting efficiency of the light-emitting diode, a light-transmitting material layer with a low refractive index may be added between an epitaxial layered structure and a metal reflective layer to form an omnidirectional reflective mirror, and at this time, a part of light emitted from an active layer downward is totally reflected back through the light-transmitting material layer, and a part of the light is totally reflected back through a high-reflective metal mirror surface layer, so as to improve light-emitting efficiency. Specifically, a material of the metal reflective layer is selected according to a light-emitting wavelength. For example, for light with a wavelength of 360 nm or more, Ag has a high reflectance, and for light with a wavelength of 360 nm or less (for example, deep ultraviolet light of 100-280 nm), A1 has a relatively higher reflectance. In some light-emitting diodes, Ag is adopted as a reflective layer, and an insulating layer is adopted as the light-transmitting material layer. Since adhesion between Ag and the insulating layer is poor, it is often necessary to add an ITO between an Ag reflective layer and the insulating layer as an adhesive layer. However, the ITO seriously absorbs a light having a relatively short wavelength, particularly within the ultraviolet wavelength range, and therefore this structure is quite difficult to effectively improve brightness of an ultraviolet light-emitting diode.

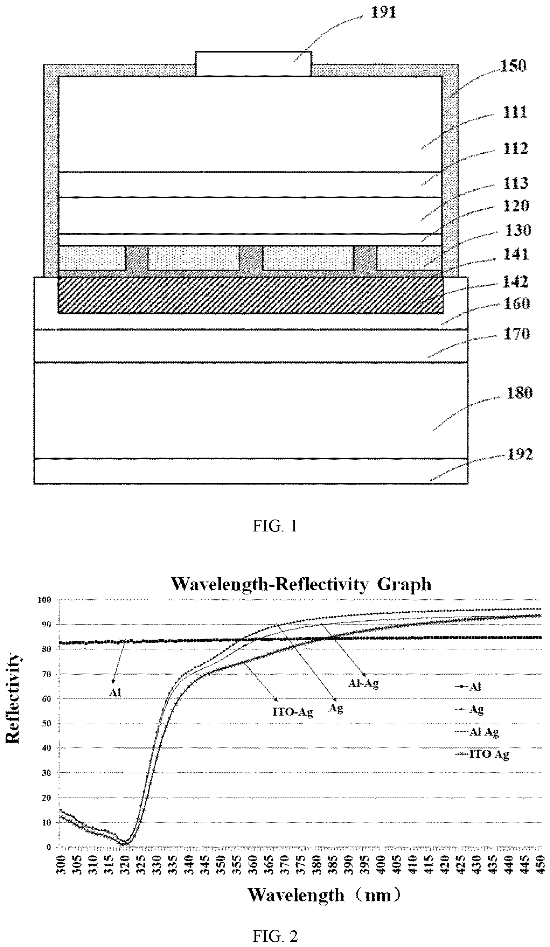

FIG. 1 shows a schematic diagram of a light-emitting diode with a light-emitting wavelength of 360-450 nm. The light-emitting diode may include, from top to bottom, a top electrode 191, a light-emitting epitaxial layered structure 110, a transparent dielectric layer 130, a first metal layer 141, a second metal layer 142, a metal protection layer 160, a bonding layer 170, a conductive substrate 180, and a back electrode 192. The light-emitting epitaxial layered structure 110 generally includes an n-type semiconductor layer 111, an active layer 112 and a p-type semiconductor layer 113, and an outer surface may be covered with an insulating protection layer 150.

Specifically, a material of the light-emitting epitaxial layered structure 110 is selected according to a light-emitting wavelength. In order to improve combined efficiency of electrons-holes, the active layer 112 may have a multi-quantum well structure. A composition element and composition ratio of the active layer 112 may be determined by the following. The active layer 112 can emit light having a required wavelength, for example, ultraviolet light having a peak wavelength of 350 nm to 400 nm. Further, a transparent conductive layer 120 may be added to a lower surface of the light-emitting epitaxial layered structure, and the transparent conductive layer may be made of a semiconductor material or a transparent conductive oxide. In this embodiment, the transparent conductive layer 120 is formed on a surface of the p-type semiconductor layer 113, and a material of the transparent conductive layer 120 may be selected from a transparent conductive oxide, such as indium tin oxide (ITO), indium oxide (InO), tin oxide (SnO), zinc oxide (ZnO), indium zinc oxide (IZnO), etc. The light-transmitting dielectric layer 130 is formed on a surface of the transparent conductive layer 120, and the thickness of the light-emitting material is preferably 50 nm or more, for example, 50-500 nm. The material of the light-transmitting dielectric layer 130 is transparent to light emitted from the light-emitting epitaxial layer 110, for example, the material is magnesium fluoride, magnesium oxide (MgO), aluminum oxide (Al₂O₃), silicon oxide (SiOx), titanium oxide (TiO₂), tantalum oxide (Ta₂O₅), silicon nitride (SiNx), etc. A series of through holes passing through the light-transmitting dielectric layer 130 is formed inside the light-transmitting dielectric layer 130. The first metal layer 141 is formed on a surface of the light-transmitting dielectric layer 130, and the thickness thereof is preferably 5 nm or less, so that the first metal layer 141 presents a noncontinuous state. The second metal layer 142 is formed on a surface of the first metal layer 141. The metal protection layer 160 is formed on a lower surface of the second metal layer 142 and covers a side surface of the second metal layer. The metal protection layer 160 is preferably made of a relatively stable metal material, such as Ti, Pt, Au, Cr, or TiW, for blocking the diffusion of the second metal layer, and may be a single-layer or multi-layer structure. The bonding layer 170 is used for bonding the light-emitting epitaxial layered structure to the conductive substrate 180 through an Au-Au bonding, an Au-In bonding, or the like.

In the present embodiment, the first metal layer 141 and the second metal layer 142 form a combined reflective mirror surface, and the material of the first metal 141 and the second metal layer 142 may include metal materials with excellent conductivity, such as Ag, Ni, Al, Rh, Pd, Ir, Ru, Mg, Zn, Pt, Au, Hf. Especially, in the present embodiment, the metal materials may be Al and Ag with high reflectance within a wavelength range of 360-450 nm. The first metal layer 141 is used for improving adhesion between the dielectric layer 130 and the second metal layer 142, and therefore the first metal layer 141 is preferably a material with good adhesion with the dielectric layer 130 and with no light absorption. In the present embodiment, the dielectric layer 130 is made of silicon oxide, the first metal layer 141 is made of Al, and the second metal layer 142 is made of Ag. The first metal layer 141 has a thickness of preferably 1 nm or less, and presents a noncontinuous state, which ensures that the reflection of the second metal layer is the dominant reflection of the reflection of the combined mirror surface. In a variant embodiment, the first metal layer may also use rhodium.

FIG. 2 shows reflectance curves of four materials within a wavelength range of 300-430 nm. As shown in FIG.2, the reflectance curve of the Al-Ag mirror surface is substantially parallel to the reflectance curve of the Ag mirror surface, and the difference between the two is within 4%. Compared to the ITO-Ag mirror surface, the reflectance of the Al-Ag mirror surface in the wavelength range of 345-410 nm is significantly improved.

**Table 1**

| wavelengt h (nm) | R1(Al-Ag) | R2(Ag) | (R2-R1)/R2 | R3(ITO-Ag) | (R1-R3)/R3 |
|---|---|---|---|---|---|
| 450 | 93.64 | 96.26 | 2.80% | 93.56 | 0.08% |
| 449 | 93.62 | 96.25 | 2.80% | 93.52 | 0.11% |
| 448 | 93.61 | 96.24 | 2.81% | 93.47 | 0.15% |
| 447 | 93.58 | 96.21 | 2.80% | 93.40 | 0.20% |
| 446 | 93.57 | 96.18 | 2.79% | 93.34 | 0.25% |
| 445 | 93.53 | 96.16 | 2.80% | 93.29 | 0.27% |
| 444 | 93.54 | 96.14 | 2.78% | 93.24 | 0.32% |
| 443 | 93.49 | 96.12 | 2.81% | 93.17 | 0.35% |
| 442 | 93.49 | 96.10 | 2.80% | 93.12 | 0.39% |
| 441 | 93.46 | 96.07 | 2.79% | 93.04 | 0.45% |
| 440 | 93.44 | 96.07 | 2.81% | 92.98 | 0.49% |
| 439 | 93.39 | 96.02 | 2.82% | 92.90 | 0.53% |
| 438 | 93.38 | 96.00 | 2.80% | 92.84 | 0.58% |
| 437 | 93.35 | 95.99 | 2.82% | 92.76 | 0.64% |
| 436 | 93.34 | 95.95 | 2.80% | 92.69 | 0.70% |
| 435 | 93.30 | 95.92 | 2.81% | 92.63 | 0.73% |
| 434 | 93.30 | 95.91 | 2.79% | 92.55 | 0.81% |
| 433 | 93.26 | 95.87 | 2.80% | 92.46 | 0.87% |
| 432 | 93.22 | 95.83 | 2.80% | 92.36 | 0.93% |
| 431 | 93.22 | 95.81 | 2.78% | 92.29 | 1.01% |
| 430 | 93.19 | 95.79 | 2.80% | 92.22 | 1.05% |
| 429 | 93.14 | 95.74 | 2.79% | 92.13 | 1.10% |
| 428 | 93.11 | 95.72 | 2.81% | 92.01 | 1.19% |
| 427 | 93.09 | 95.69 | 2.80% | 91.93 | 1.26% |
| 426 | 93.04 | 95.67 | 2.82% | 91.83 | 1.32% |
| 425 | 93.01 | 95.63 | 2.82% | 91.72 | 1.41% |
| 424 | 92.99 | 95.58 | 2.79% | 91.62 | 1.49% |
| 423 | 92.94 | 95.55 | 2.81% | 91.52 | 1.55% |
| 422 | 92.91 | 95.53 | 2.82% | 91.42 | 1.63% |
| 421 | 92.86 | 95.47 | 2.81% | 91.30 | 1.71% |
| 420 | 92.84 | 95.43 | 2.79% | 91.21 | 1.79% |
| 419 | 92.82 | 95.42 | 2.80% | 91.08 | 1.92% |
| 418 | 92.78 | 95.36 | 2.78% | 90.96 | 1.99% |
| 417 | 92.75 | 95.32 | 2.78% | 90.84 | 2.10% |
| 416 | 92.70 | 95.29 | 2.79% | 90.72 | 2.19% |
| 415 | 92.64 | 95.25 | 2.81% | 90.57 | 2.29% |
| 414 | 92.58 | 95.18 | 2.81% | 90.47 | 2.33% |
| 413 | 92.58 | 95.13 | 2.76% | 90.33 | 2.48% |
| 412 | 92.54 | 95.11 | 2.78% | 90.21 | 2.58% |
| 411 | 92.50 | 95.06 | 2.77% | 90.07 | 2.69% |
| 410 | 92.44 | 95.00 | 2.78% | 89.93 | 2.79% |
| 409 | 92.39 | 94.95 | 2.77% | 89.76 | 2.93% |
| 408 | 92.33 | 94.91 | 2.80% | 89.63 | 3.01% |
| 407 | 92.32 | 94.84 | 2.73% | 89.51 | 3.14% |
| 406 | 92.24 | 94.79 | 2.77% | 89.33 | 3.26% |
| 405 | 92.18 | 94.72 | 2.76% | 89.18 | 3.36% |
| 404 | 92.11 | 94.67 | 2.78% | 89.04 | 3.45% |
| 403 | 92.04 | 94.59 | 2.77% | 88.85 | 3.59% |
| 402 | 91.96 | 94.52 | 2.78% | 88.68 | 3.70% |
| 401 | 91.93 | 94.49 | 2.79% | 88.55 | 3.82% |
| 400 | 91.86 | 94.44 | 2.80% | 88.38 | 3.94% |
| 399 | 91.76 | 94.38 | 2.85% | 88.20 | 4.04% |
| 398 | 91.71 | 94.27 | 2.78% | 88.00 | 4.22% |
| 397 | 91.57 | 94.15 | 2.82% | 87.78 | 4.31% |
| 396 | 91.55 | 94.13 | 2.81% | 87.66 | 4.44% |
| 395 | 91.41 | 94.02 | 2.85% | 87.37 | 4.63% |
| 394 | 91.37 | 93.93 | 2.80% | 87.22 | 4.76% |
| 393 | 91.24 | 93.83 | 2.84% | 86.96 | 4.91% |
| 392 | 91.20 | 93.73 | 2.77% | 86.83 | 5.04% |
| 391 | 91.05 | 93.62 | 2.82% | 86.53 | 5.22% |
| 390 | 90.94 | 93.53 | 2.85% | 86.30 | 5.37% |
| 389 | 90.86 | 93.44 | 2.84% | 86.08 | 5.55% |
| 388 | 90.79 | 93.34 | 2.81% | 85.81 | 5.80% |
| 387 | 90.62 | 93.21 | 2.86% | 85.57 | 5.90% |
| 386 | 90.48 | 93.11 | 2.90% | 85.33 | 6.03% |
| 385 | 90.37 | 92.91 | 2.82% | 85.05 | 6.25% |
| 384 | 90.21 | 92.78 | 2.85% | 84.78 | 6.41% |
| 383 | 90.06 | 92.66 | 2.88% | 84.47 | 6.62% |
| 382 | 89.93 | 92.56 | 2.92% | 84.19 | 6.82% |
| 381 | 89.77 | 92.41 | 2.94% | 83.90 | 6.99% |
| 380 | 89.67 | 92.31 | 2.94% | 83.59 | 7.27% |
| 379 | 89.41 | 92.13 | 3.04% | 83.25 | 7.41% |
| 378 | 89.17 | 91.86 | 3.02% | 82.87 | 7.60% |
| 377 | 89.10 | 91.81 | 3.04% | 82.58 | 7.89% |
| 376 | 88.84 | 91.54 | 3.04% | 82.19 | 8.09% |
| 375 | 88.66 | 91.38 | 3.07% | 81.89 | 8.26% |
| 374 | 88.36 | 91.13 | 3.14% | 81.51 | 8.40% |
| 373 | 88.08 | 90.85 | 3.15% | 81.07 | 8.65% |
| 372 | 87.87 | 90.64 | 3.16% | 80.74 | 8.83% |
| 371 | 87.56 | 90.34 | 3.17% | 80.30 | 9.04% |
| 370 | 87.35 | 90.09 | 3.14% | 79.92 | 9.30% |
| 369 | 87.01 | 89.83 | 3.24% | 79.52 | 9.41% |
| 368 | 86.66 | 89.50 | 3.27% | 79.13 | 9.52% |
| 367 | 86.22 | 89.21 | 3.46% | 78.70 | 9.55% |
| 366 | 85.80 | 88.82 | 3.51% | 78.27 | 9.62% |
| 365 | 85.59 | 88.55 | 3.46% | 77.92 | 9.85% |
| 364 | 85.05 | 88.05 | 3.54% | 77.39 | 9.89% |
| 363 | 84.64 | 87.62 | 3.52% | 77.04 | 9.88% |
| 362 | 84.13 | 87.14 | 3.58% | 76.70 | 9.69% |
| 361 | 83.71 | 86.70 | 3.57% | 76.33 | 9.66% |
| 360 | 83.03 | 86.03 | 3.61% | 75.94 | 9.34% |

Table 1 shows the reflectance of the three reflective structures within the wavelength range of 360-450 nm. It can be seen that The combined reflectance of the reflector with Al-Ag structure differs from the reflectance of the Ag mirror within 4%, while the reflectance is greatly increased compared with the reflectance of the ITO-Ag mirror surface, especially for ultraviolet light of 400-360 nm, the reflectance is increased by 4-9%.

Since the above light-emitting diode adopts the dielectric layer 130, the first metal layer and the second metal layer as reflective structures, the adhesion between the reflective mirror surface and the dielectric layer is ensured while the brightness is increased.

### Embodiment 2

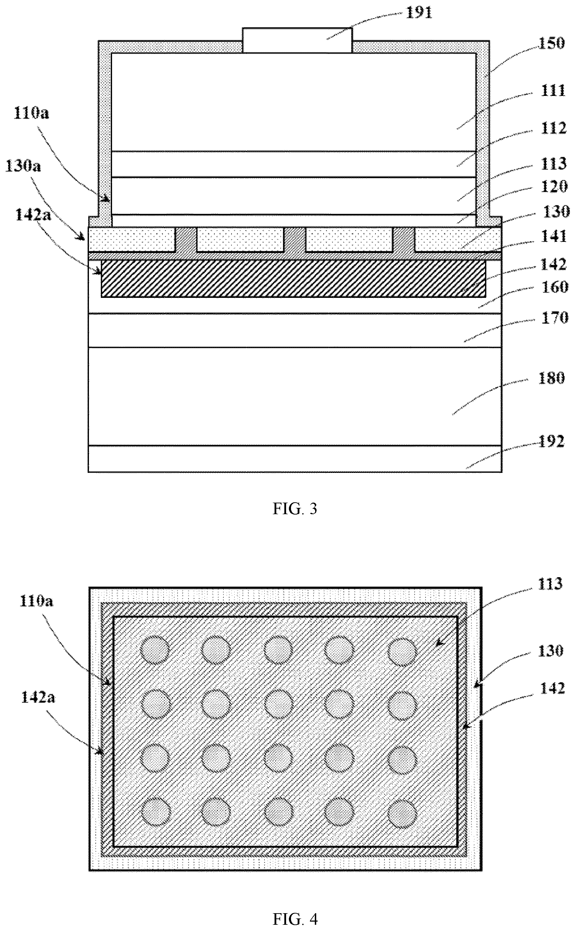

FIG. 3 shows a schematic diagram of another light-emitting diode. The difference from the light-emitting diode shown in FIG. 1 is that an area of the metal mirror surface 142 located below the light-emitting epitaxial layered structure 110 is greater than an area of the metal mirror surface 142 of the light-emitting diode shown in FIG. 1, and more preferably, the area of the metal mirror surface is equal to an area of the epitaxial layered structure, and even greater than the area of the light-emitting epitaxial layered structure, so that the light-emitting region can be increased and the light-emitting brightness can be improved. FIG. 4 shows an area relationship among the light-emitting epitaxial layered structure 110, the dielectric layer 130 and the second metal layer 142 (i.e. the metal mirror surface layer). It can be seen from the figure that an edge 130a of the dielectric layer 130 exceeds an edge 110a of the light-emitting epitaxial layered structure and reaches a certain distance, so that an edge of the second metal layer 142 exceeds an edge 110a of the light-emitting epitaxial layered structure.

Preferably, a distance between an edge 142a of the second metal layer and an edge 110a of the light-emitting epitaxial layered structure is 0-50 microns, and for example, is 10-20 microns.

### Embodiment 3

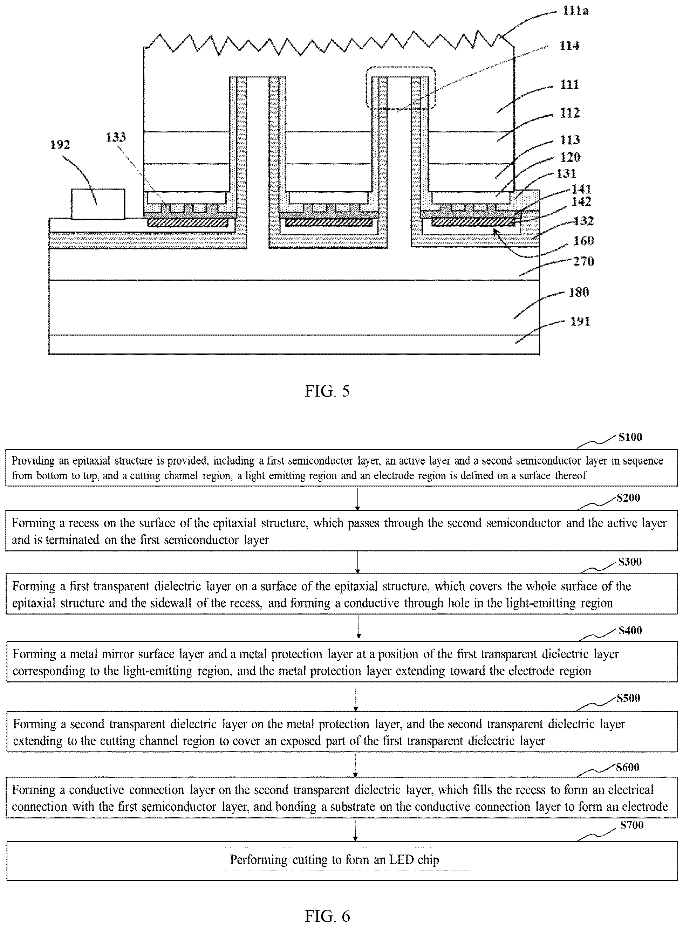

FIG. 5 shows a schematic diagram of another light-emitting diode with a light-emitting wavelength of 360-450 nm. The light-emitting diode may include a light-emitting epitaxial layered structure 110, a transparent conductive layer 120, a first transparent dielectric layer 131, a first metal layer 141, a second metal layer 142, a metal protection layer 160, a second transparent dielectric layer 132, a conductive connection layer 270, a substrate 180, and electrodes 191 and 192.

Specifically, the light-emitting epitaxial layered structure 110 includes, from top to bottom, a first semiconductor layer 111, an active layer 112 and a second semiconductor layer 113 and has at least one recess 114. The recess 114 extends from a lower surface of the light-emitting epitaxial layered structure to the first-typed semiconductor layer 111 through the second semiconductor layer 113 and the active layer 112. The first transparent dielectric layer 131 is formed on a surface of the transparent conductive layer 120, and covers a sidewall of the recess 114. The first transparent dielectric layer 131 has a series of conductive through holes 133 that expose a part of the surface of the transparent conductive layer 120. The first metal layer 141 is formed on a surface of the transparent dielectric layer 131, and is in contact with the surface of the exposed transparent conductive layer 120. The second metal layer 142 is formed on the surface of the first metal layer 141, and forms a combined reflective mirror surface with the first metal layer 141. The metal protection layer 160 is formed on a surface of the second metal layer 142, covers a sidewall of the second metal layer 142, and meanwhile, a part of the surface of the second metal layer 142 may be exposed for providing the second electrode 192. The metal protection layer 160 is preferably made of a relatively stable metal material for blocking the diffusion of the second metal layer and may be a single-layer or multi-layer structure. The second transparent dielectric layer 132 is formed on a surface of the protection layer 160 away from the light-emitting epitaxial layered structure, and preferably may cover the sidewall of the recess 114 at the same time. The material of the second transparent dielectric layer 132 may be the same as or may be different from the material of the first transparent dielectric layer 131. For example, magnesium fluoride, magnesium oxide (MgO), aluminum oxide (Al₂O₃), silicon oxide (SiOx), titanium oxide (TiO₂), tantalum oxide (Ta₂O₅), silicon nitride (SiNₓ), or the like may be selected as the material of the second transparent dielectric layer 132. In other embodiments, the second transparent dielectric layer 132 does not cover the sidewall of the recess 114. The conductive connection layer 270 is formed on the surface of the second transparent dielectric layer 132, fills the recess 114, and forms an electrical contact with the first semiconductor layer 111. The conductive connection layer 270 may include a reflective material such as Al, Cr, or Ag, contacts with the first semiconductor layer 111, and also includes a bonding material for bonding to the substrate 180. The substrate 180 is formed on a surface of a side of the conductive connection layer 270 away from the light-emitting epitaxial layered structure 110, and is preferably made of a material having good heat dissipation properties such as Si, Cu, or ceramic. The first electrode 191 is formed on a back surface of the substrate 180. An electrical connection is formed with the first semiconductor layer 111 through the conductive connection layer 270. The second electrode 192 is formed on the surface of the exposed metal protection layer 160. The metal protection layer 160, the second metal layer 142, the first metal layer 141, the transparent conductive layer 120 and the second semiconductor layer 113 form an electrical connection. Electrical isolation is achieved between the metal protection layer 160 and the conductive connection layer 270 through the second transparent dielectric layer 132. The first transparent dielectric layer 131 and form an omnidirectional reflective structure, and the material, thickness and the like thereof can be selected with reference to Embodiment 1.

In the present embodiment, the conductive connection layer 270 is connected to the heat-dissipating substrate 180 and the first semiconductor layer 111, respectively, to form a good heat conducting channel that guides the heat from the first semiconductor layer to the heat-dissipating substrate. Since an excitation radiation of the active layer is emitted through the first semiconductor layer, heat tends to gather at the first semiconductor layer. The conductive connection layer of the present embodiment can effectively guide the heat from the first semiconductor layer to the heat-dissipating substrate. The recess 114 may be terminated on a lower surface of the first semiconductor layer 111, or may extend into the first semiconductor layer 111 and resides inside the first semiconductor layer. For example, in some specific embodiments, the first semiconductor layer has a relatively thin thickness (e.g., 2 microns or even thinner), and in this case, the recess 114 extends through the second semiconductor layer 113 and the active layer, and terminates on a lower surface of the first semiconductor layer 111 (a surface adjacent to the active layer). In other specific embodiments, the first semiconductor layer 111 has a relatively large thickness (for example, 2 micrometers or more), and in this case, the recess 114 preferably extends into the first semiconductor layer 111, and heat from the first semiconductor layer 111 can be guided to outside better. For example, the thickness of the first semiconductor layer 111 is from 2 µm to 3 µm, and the depth of the recess 111 inside the first semiconductor layer 111 may be 1 micron or more.

### Embodiment 4

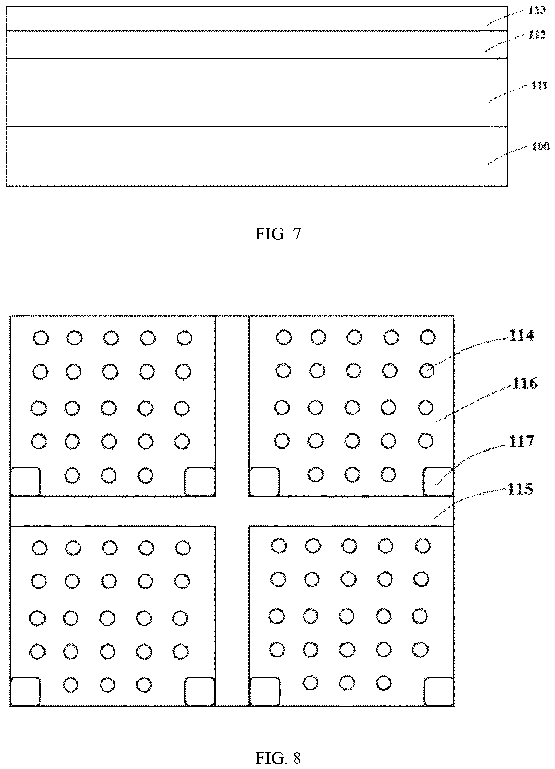

FIG. 6 shows a process for manufacturing a light-emitting diode chip, which generally includes steps S100-S700. FIGS. 7-19 schematically illustrate structural cross section at different stages. Detailed description will be given below with reference to FIGS. 7-19.

At step S100, an epitaxial structure is provided, including a first semiconductor layer, an active layer and a second semiconductor layer in sequence from bottom to top, and a cutting channel region, a light-emitting region and an electrode region are defined on a surface thereof. Specifically, firstly, an epitaxial structure is provided, that includes a growth substrate 100, and a light-emitting epitaxial layered structure 110 formed on the growth substrate 100 in sequence. The light-emitting epitaxial layered structure includes a first semiconductor layer 111, an active layer 112 and a second semiconductor layer 113, as shown in FIG. 7. The selection of the growth substrate 110 includes, but is not limited to, sapphire, aluminum nitride, gallium nitride, silicon, silicon carbide, gallium arsenide, and the surface structure thereof may be a planar structure or a patterned structure. When the first semiconductor layer is a p-type semiconductor, the second semiconductor layer may be an n-type semiconductor having an opposite electrical property, and vice versa, when the first semiconductor layer is an n-type semiconductor, the second semiconductor layer may be a p-type semiconductor having an opposite electrical property. The active layer may be a neutral, p-type or n-type semiconductor. When current passes through the semiconductor light-emitting epitaxial layered structure, the active layer is excited to emit light. The material of the active layer is selected according to the light-emitting wavelength. When a material based on the nitride is used, blue, green or ultraviolet light may be emitted. When a material based on aluminum indium gallium phosphide is used, light of an amber color series including red, orange, and yellow light may be emitted. Next, a cutting channel region 115, a light-emitting region 116 and an electrode region 116 are defined on an upper surface of the epitaxial structure. The light-emitting region 116 generally corresponds to one chip, and includes a series of patterns for recesses 114 , and at least one electrode region 117, as shown in FIG. 8.

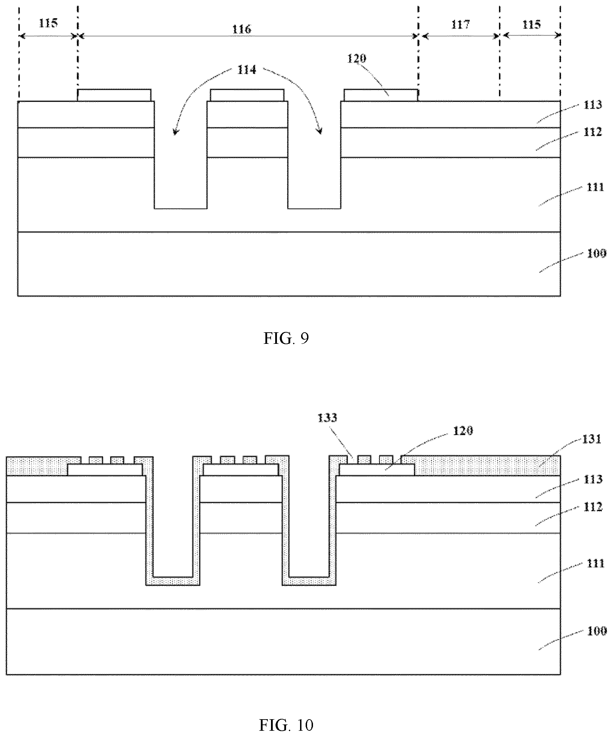

At step 200, a series of recesses 114 are formed on the surface of the epitaxial structure, which extend through the second semiconductor 113 and the active layer 112 and reside at the first semiconductor layer 111. Preferably, a transparent conductive layer 120 is formed on a light-emitting region of the light-emitting epitaxial layered structure, as shown in FIG. 9.

At step 300, a first transparent dielectric layer 131 is formed on a surface of the epitaxial layered structure, which covers the sidewall of the cutting channel region 115, the light-emitting region 116 and the recess 114 at the same time. A series of conductive through holes 133 are formed on the light-emitting region 116, as shown in FIG. 10.

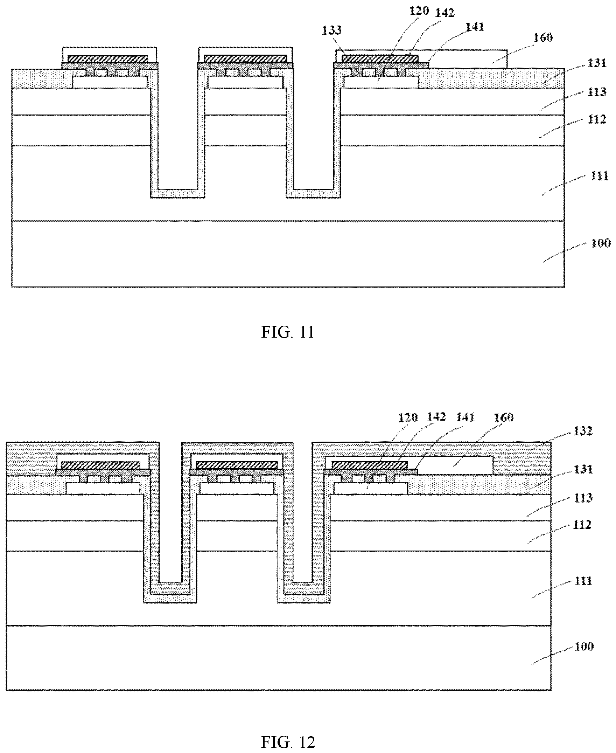

At step 400, a metal mirror surface layer and a metal protection layer 160 are sequentially formed at the light-emitting region. The metal protection layer 160 extends toward the electrode regions 117 and covers the insulating layer of the second electrode region. Specifically, the metal mirror surface layer may be a single-layer structure or a multi-layer structure. The material of the metal mirror surface layer is preferably a material capable of highly reflecting light emitted from the active layer. For example, the silver mirror has a high reflectance for light above 360 nm. The aluminum mirror has a high reflectance for ultraviolet light below 360 nm. When a silver mirror surface is used as the mirror surface, the adhesion to the transparent dielectric layer 131 is poor. In this case, a material layer needs to be added between the silver mirror and the transparent dielectric layer 131 as an adhesion layer. In some embodiments where the wavelength of the light emitted from the active layer 112 is 400 nm or more, Ag is selected as the metal mirror surface, and an ITO thin layer is added between the Ag mirror surface layer 142 and the first transparent dielectric layer 131 as an adhesion layer, so as to increase the adhesion between the Ag mirror surface and the first transparent dielectric layer 131. In other embodiments where the light-emitting wavelength of the active layer 112 is 360-450 nm, since the ITO has a severe light absorption effect in a short wavelength range, it is preferable to add an aluminum thin film layer 141 between the silver mirror surface layer and the first transparent dielectric layer 131. Aluminum has better adhesion to the insulating material, and has no light absorption effect on short-wavelength light, and thus can ensure the reflectance and the reliability of the mirror structure simultaneously. In other embodiments, the emission wavelength of light of the active layer 112 is 360 nm or less, and aluminum or rhodium may be directly used as the mirror surface layer. Referring to FIG. 11, in this embodiment, a two-layer structure of a metal mirror surface layer is taken as an example, in which a first layer is an aluminum metal layer 141 and the second layer is a silver metal layer. The thickness of the aluminum metal layer is 50 angstroms or less, for example, 1-10 angstroms, and the thickness of the silver metal layer is 1000-5000 angstroms, for example, 2000 angstroms. The metal protection layer 160 covers the silver metal surface layer 142 and covers the electrode regions 117.

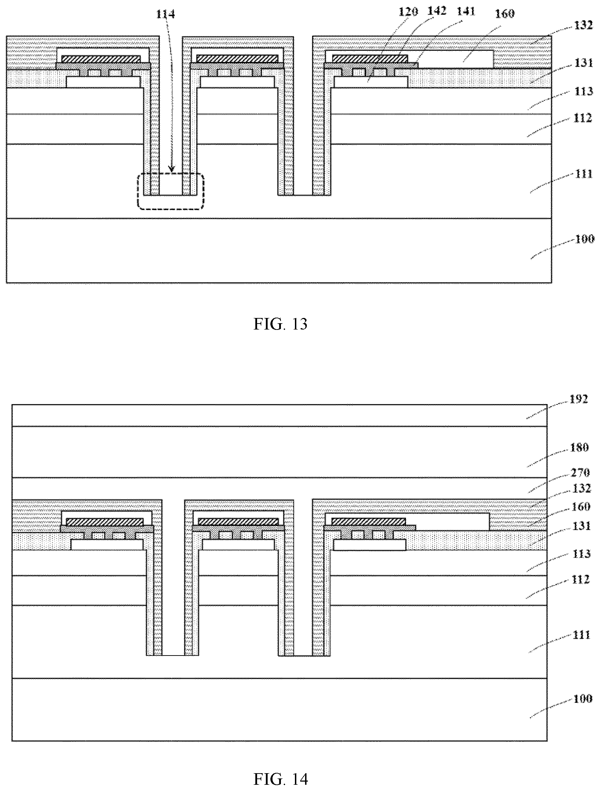

At step 500, a second transparent dielectric layer 132 is formed, which covers the metal protection layer 160 and extends to the cutting channel region 115 to cover the first transparent dielectric layer 131 on the cutting channel region 115. Preferably, the second transparent dielectric layer 132 at the same time covers the surface of the recess 114, as shown in FIG. 12. In this case, it is generally necessary to remove the first transparent dielectric layer and the second transparent dielectric layer at the bottom of the recess 114, and expose the surface of the first semiconductor layer 111, as shown in FIG. 13.

At step 600, a conductive connection layer 170 is formed on the second transparent dielectric layer 132, and fills the recess 114, forming an electrical connection with the first semiconductor layer 111. A substrate 180 is bonded on the conductive connection layer 170, and an electrode 191 is formed on a back surface of the substrate 180, as shown in FIG. 14.

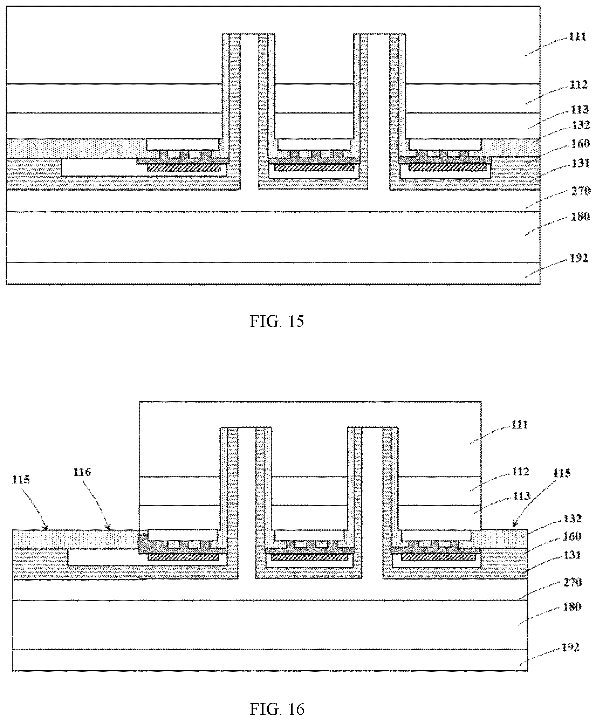

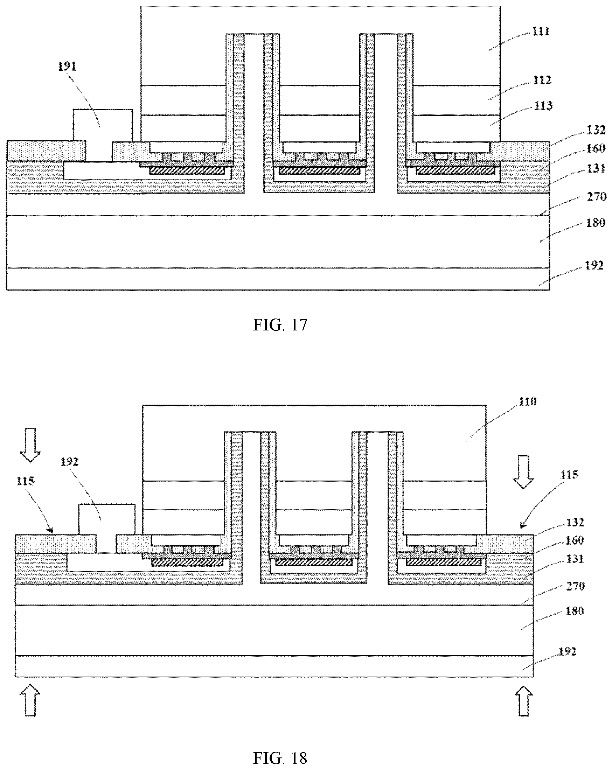

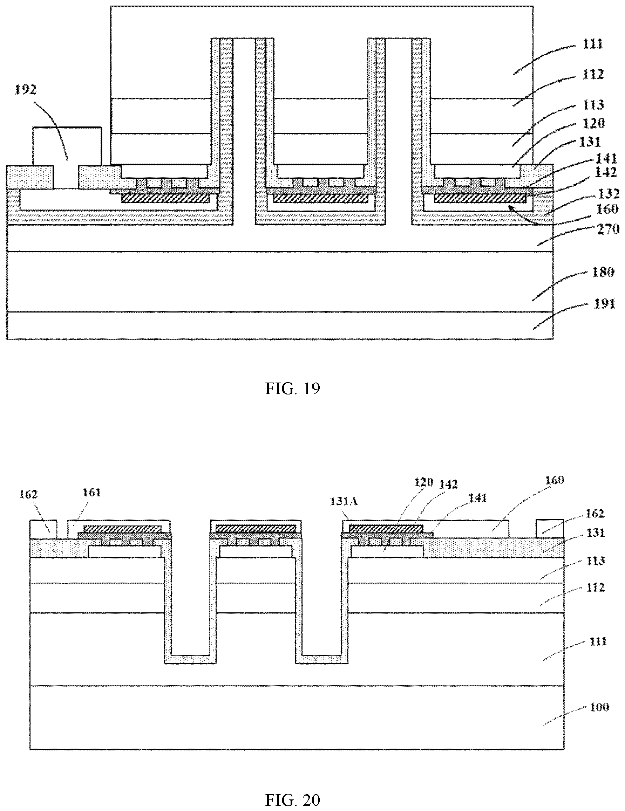

At step 700, cutting is performed to form an LED chip. In the present embodiment, the method may further include removing a growth substrate, etching to remove the epitaxial layered structure at the cutting channel region and the electrode regions, and forming electrodes, and the like. Specifically, the growth substrate 100 is first removed, and a surface of the first semiconductor layer 111 away from the active layer is exposed, as shown in FIG. 15. Next, the light-emitting epitaxial layered structure corresponding to the cutting channel region 115 and the electrode regions 117 is removed, and the first transparent dielectric layer 115 is exposed, as shown in FIG. 16. An electrode 192 is formed in the electrode region, as shown in FIG. 17, and finally, a single LED chip is formed by cutting and cleaving. In the present embodiment, referring to FIG. 18, a laser may be first used for front scribing, followed by back scribing, and then cleaving is performed to form a series of LED chips, as shown in FIG. 19.

### Embodiment 5

In the process of manufacturing the light-emitting diode, when the last cutting process is performed, the structure of the cutting channel region 115 is sequentially a first transparent dielectric layer 131, a second transparent dielectric layer 132, and a conductive connection layer 170. The material of the first transparent dielectric layer and the second transparent dielectric layer is usually an insulating material, such as silicon oxide, silicon nitride, or the like. When the laser is used for front scribing, the laser heat will easily accumulate at the insulating layer and cause explosion.

Based on this, the present embodiment discloses another method for manufacturing a light-emitting diode. Steps S100 to S300 refer to Embodiment 4. FIG. 20 to FIG. 24 are schematic diagrams showing the structure presented in some steps of the manufacturing process, and will be described in detail below with reference to the accompanying drawings.

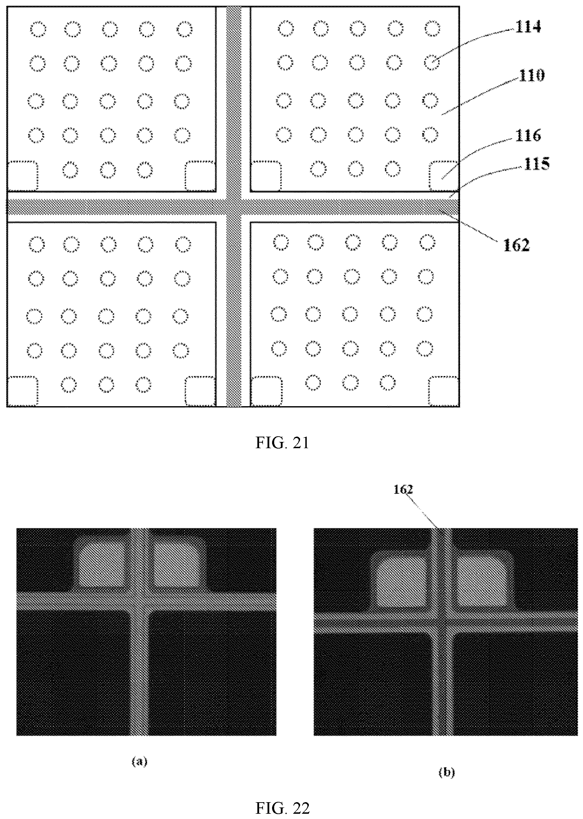

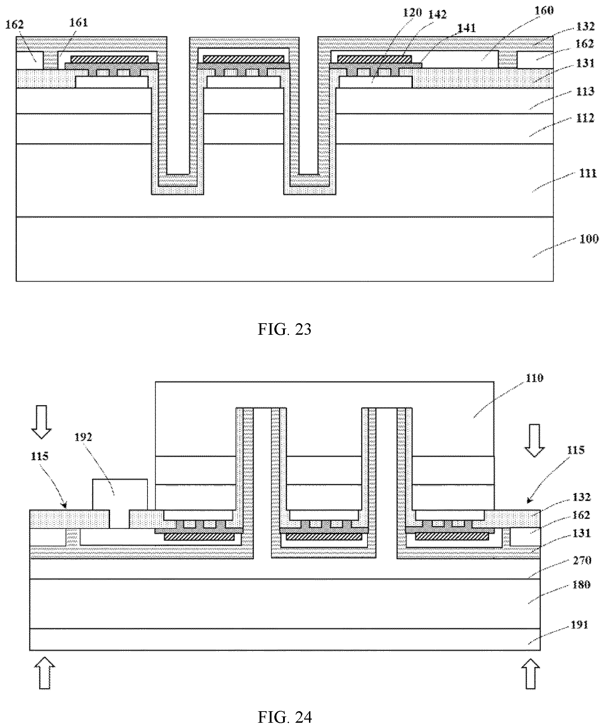

Differing from Embodiment 4, in step 400 of the present embodiment, a metal material layer 162 is formed on the first transparent dielectric layer 131 of the cutting channel region 115, and the material of the metal material layer 162 may be the same as the material of the metal protection layer 160, or may be different. In order to simplify the process, the material of the metal material layer 162 is preferably the same as the material of the metal protection layer 160. Preferably, the metal material layer 162 is electrically isolated from the metal protection layer 160, as shown in FIG. 20. FIG. 21 simply illustrates the distribution of the metal material layer 162, e.g., formed in a middle region of the cutting channel region 116. FIG. 22 shows an SME photograph of the cutting channel shown in Embodiment 4 and the cutting channel of this embodiment. As can be seen from the figure, in this embodiment, a metal material layer 162 is formed in the middle of the cutting channel. FIG. 23 shows a cross-sectional view after step S500 is completed, and at this time, a first transparent dielectric layer 131, a metal material layer 162 and a second transparent dielectric layer 132 are sequentially provided in the cutting channel region 115 on the surface of the epitaxial structure. FIG. 24 schematically illustrates a schematic diagram of performing front scribing and back cutting after step 600 is completed. When performing laser front scribing, since the metal has better heat dissipation property than that of the insulating layer, the metal material layer 162 in the cutting channel region can absorb the scribing laser thermal energy and reduce the explosion phenomenon caused by excessive laser scribing heat.

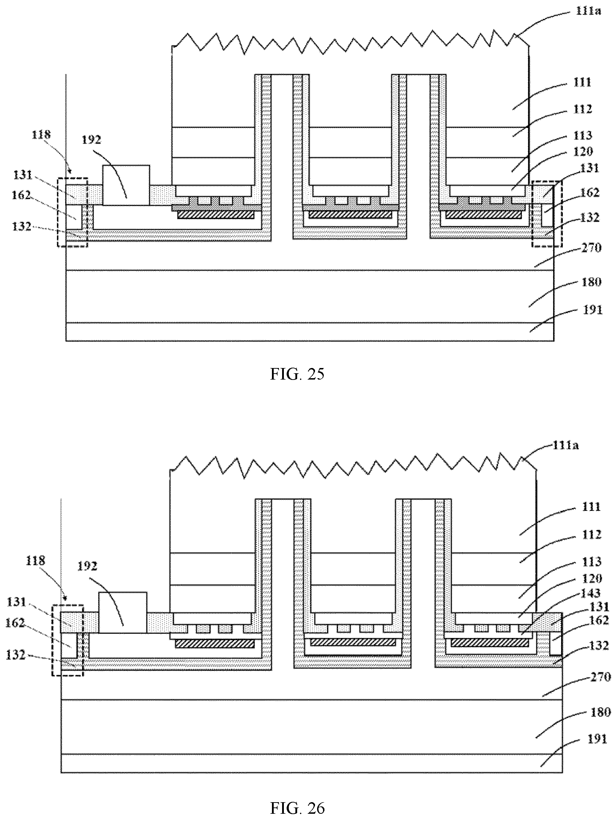

FIG. 25 shows a structural cross-sectional view of a light-emitting diode formed by the above method. The structure of the light-emitting diode and the light-emitting diode shown in FIG. 5 are basically the same, and the difference lies in that the edge structure of the device is different. Specifically, the light-emitting diode includes a light-emitting epitaxial layered structure and a material layer below the light-emitting epitaxial layered structure. The material layer below has an edge part 118 exceeding the light-emitting epitaxial layered structure. The edge part 118 includes a first transparent dielectric layer 131, a second transparent dielectric layer 132 made of an insulating material, and a metal material layer 162 sandwiched between the first transparent dielectric layer 131 and the second transparent dielectric layer 132. The material of the metal material layer 162 may be the same as the material of the metal protection layer 160, or may be different.

In the present embodiment, the conductive connection layer 170 includes a metal bonding layer for bonding the substrate 180. Filling the metal material layer 162 when cutting the channel reduce the void ratio of the metal bonding layer at the edge region of the device.

### Embodiment 6

FIG. 26 is a schematic diagram showing a light-emitting diode having a light-emitting wavelength of 450 nm or more. The light-emitting diode and the light-emitting diode shown in FIG. 5 have substantially the same structure, and the difference lies in that the mirror surfaces have different structures. Since the light-emitting wavelength is 450 nm or more, an ITO-Ag structure is adopted as a mirror surface structure. An ITO layer 143 acts as an adhesive layer with a thickness of preferably less than 10 nm.

### Embodiment 7

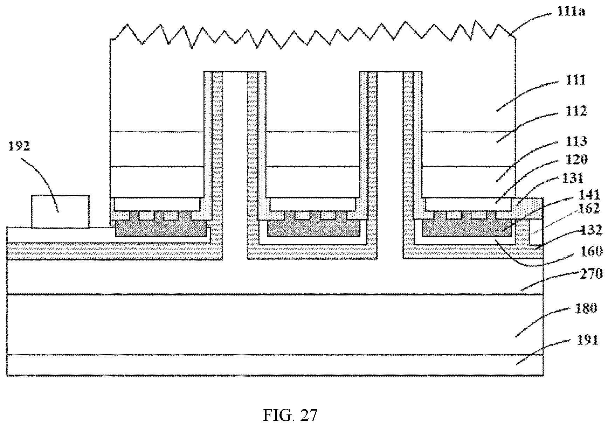

FIG. 27 is a schematic diagram showing a light-emitting diode having a light-emitting wavelength of 360 nm or less. The light-emitting diode and the light-emitting diode shown in FIG. 5 have substantially the same structure, and the difference lies in that the mirror surfaces have different structures. Since the light-emitting wavelength is 360 nm or more, the aluminum reflective layer 141 is directly adopted as a mirror surface, and may have a thickness ranging from 1000 Å to 5000 Å.

The above are only the preferred embodiments of the present invention, and should not be used to limit the scope of implementation of the present invention. That is, Simple equivalent changes and modifications made in accordance with the patent scope of the present application and the description of the patent are all within the scope of the present invention.

## Claims

1. A light-emitting diode comprising:
a light-emitting epitaxial layered structure comprising a first semiconductor layer, an active layer and a second semiconductor layer, and having a first surface and a second surface corresponding to each other;
a light-transmitting layer formed on the second surface of the light-emitting epitaxial layered structure;
a first metal layer formed on a surface of the light-transmitting layer away from the light-emitting epitaxial layered structure;
a second metal layer formed on a surface of the first metal layer away from the light-emitting epitaxial layered structure;
**characterized in that**, the first metal layer and the second metal layer form a mirror surface structure, the first metal layer having a reflectance R1 to light emitted from the light-emitting epitaxial layered structure, the second metal layer having a reflectance R2 to light emitted from the light-emitting epitaxial layered structure, the first metal layer and the second metal layer having a combined reflectance R3 to the light emitted from the light-emitting epitaxial layered structure, wherein R1< R2, and (R2-R3)/R2<4%.

2. The light-emitting diode according to claim 1, **characterized in that**, an emission wavelength of the light-emitting epitaxial layered structure is 360-450 nm.

3. The light-emitting diode according to claim 1, **characterized in that**, an emission wavelength of the light-emitting epitaxial layered structure is 385-450 nm, and the combined reflectance of the first metal layer and the second metal layer is 90% or more.

4. The light-emitting diode according to claim 1, **characterized in that**, an emission wavelength of the light-emitting epitaxial layered structure is 365-450 nm, and the combined reflectance of the first metal layer and the second metal layer is 85% or more.

5. The light-emitting diode according to claim 1, **characterized in that**, the light-transmitting layer is an insulating material layer.

6. The light-emitting diode according to claim 3, **characterized in that**, a thickness of the light-transmitting layer is 5000 angstroms or less.

7. The light-emitting diode according to claim 1, **characterized in that**, the first metal layer is in a noncontinuous state.

8. The light-emitting diode according to claim 1, **characterized in that**, a thickness of the first metal layer is not greater than 50 angstroms.

9. The light-emitting diode according to claim 1, **characterized in that**, a thickness of the second metal layer is 100-5000 angstroms.

10. The light-emitting diode according to claim 1, **characterized in that**, the first metal layer is an aluminum layer or a rhodium layer, and the second metal layer is a silver layer.

11. The light-emitting diode according to claim 1, **characterized in that**, an edge of the second metal layer exceeds an edge of the light-emitting epitaxial layered structure.

12. The light-emitting diode according to claim 1, **characterized in that**, the light-emitting epitaxial layered structure is defined as an upper part, a structure below the second surface of the light-emitting epitaxial layered structure is defined as a lower part, the lower part having an edge part exceeding an edge of the light-emitting epitaxial layered structure, and the edge part comprising at least a first insulating layer, a metal material layer and a second insulating layer from top to bottom.

13. The light-emitting diode according to claim 12, **characterized by** further comprising a metal protection layer formed between the second metal layer and the insulating layer and covering the second metal layer, the metal material layer at the edge part being the same as the metal protection layer.

14. The light-emitting diode according to claim 12, **characterized in that**, the metal material layer at the edge part is located at an outermost side of the outer edge part.

15. The light-emitting diode according to claim 1, further comprising:
an insulating layer formed on a surface of the second metal layer away from the light-emitting epitaxial layered structure;
a conductive connection layer formed on a surface of the insulating layer away from the light-emitting epitaxial layered structure;
wherein the light-emitting epitaxial layered structure has at least one recess, and the recess extends from the second surface of the light-emitting epitaxial layered structure through the second semiconductor layer and the active layer to the first-typed semiconductor layer, the light-transmitting layer being made of an insulating material and covering a sidewall of the recess at the same time, the conductive connection layer filling the recess to form an electrical connection with the first semiconductor layer.

16. The light-emitting diode according to claim 15, **characterized in that**, the light-emitting epitaxial layered structure is defined as an upper part, a structure below the second surface of the light-emitting epitaxial layered structure is defined as a lower part, the lower part has an edge part exceeding an edge of the light-emitting epitaxial layered structure, the edge part at least comprising a light-transmitting layer, a metal material layer and an insulating layer from top to bottom.

17. The light-emitting diode according to claim 16, **characterized by** further comprising a metal protection layer formed between the second metal layer and the insulating layer and covering the second metal layer, the metal material layer at the edge part being the same as the metal protection layer.

18. An ultraviolet light-emitting diode, comprising:
a light-emitting epitaxial layered structure comprising a first semiconductor layer, an active layer and a second semiconductor layer, and having a first surface and a second surface corresponding to each other;
a light-transmitting layer formed on the second surface of the light-emitting epitaxial layered structure;
a first conductive layer formed on a surface of the light-transmitting layer away from the light-emitting epitaxial layered structure;
a second conductive layer formed on a surface of the first conductive layer away from the light-emitting epitaxial layered structure;
**characterized in that**, the first conductive layer and the second conductive layer form a mirror surface structure, the first conductive layer having a reflectance R2 to light emitted from the light-emitting epitaxial layered structure, the second conductive layer having a reflectance R2 to light emitted from the light-emitting epitaxial layered structure, the first conductive layer and the second conductive layer having a combined reflectance R3 to the light emitted from the light-emitting epitaxial layered structure, wherein R1< R2, and (R2-R3)/R2<4%.

19. The light-emitting diode according to claim 18, **characterized in that**, the light-transmitting layer is an insulating material layer.

20. The light-emitting diode according to claim 18, **characterized in that**, a thickness of the light-transmitting layer is 5000 angstroms or less.

21. The light-emitting diode according to claim 18, **characterized in that**, the first conductive layer is in a noncontinuous state.

22. The light-emitting diode according to claim 18, **characterized in that**, a thickness of the first conductive layer is 50 angstroms or less.

23. The light-emitting diode according to claim 18, **characterized in that**, a thickness of the second conductive layer is 100-5000 angstroms.

24. The light-emitting diode according to claim 18, **characterized in that**, the first conductive layer is an aluminum layer or a rhodium layer, and the second conductive layer is a silver layer.

25. The light-emitting diode according to claim 18, **characterized in that**, the light-emitting epitaxial layered structure is defined as an upper part, a structure below the second surface of the light-emitting epitaxial layered structure is defined as a lower part, the lower part has an edge part exceeding an edge of the light-emitting epitaxial layered structure, and the edge part at least comprises a first insulating layer, a metal material layer and a second insulating layer from top to bottom.

26. The light-emitting diode according to claim 25, **characterized by** further comprising a metal protection layer formed between the second metal layer and the insulating layer and covering the second metal layer, the metal material layer at the edge part is the same as the metal protection layer.

27. The light-emitting diode according to claim 25, **characterized in that**, the metal material layer at the edge part is located at the outermost side of the outer edge part.

28. The light-emitting diode according to claim 18, **characterized by** further comprising:
an insulating layer formed on a surface of the second metal layer away from the light-emitting epitaxial layered structure;
a conductive connection layer formed on a surface of the insulating layer away from the light-emitting epitaxial layered structure;
the light-emitting epitaxial layered structure has at least one recess, and the recess extends from the second surface of the light-emitting epitaxial layered structure through the second semiconductor layer and the active layer to the first-typed semiconductor layer, the light-transmitting layer is made of an insulating material, and covers a sidewall of the recess at the same time, and the conductive connection layer fills the recess to form an electrical connection with the first semiconductor layer.

29. The light-emitting diode according to claim 28, **characterized in that**, the light-emitting epitaxial layered structure is defined as an upper part, a structure below the second surface of the light-emitting epitaxial layered structure is defined as a lower part, the lower part has an edge part exceeding an edge of the light-emitting epitaxial layered structure, and the edge part at least comprises a light-transmitting layer, a metal material layer and an insulating layer from top to bottom.

30. The light-emitting diode according to claim 29, **characterized by** further comprising a metal protection layer formed between the second metal layer and the insulating layer and covering the second metal layer, wherein the metal material layer at the edge part is the same as the metal protection layer.
